# EUROPEAN PATENT APPLICATION

(11) **EP 4 239 834 A1**
(43) Date of publication of application: **06.09.2023**
(21) Application number: 21886227.4
(22) Date of filing: 26.10.2021
(51) Int. Cl.: H02J 7/04, H01M 10/44, H01M 10/48

(54) **POWER STORAGE DEVICE, CHARGING METHOD, AND PROGRAM**

(30) Priority: 27.10.2020 JP 2020179847
(71) Applicant: Kyocera Corporation, Kyoto-shi, Kyoto 612-8501 (JP)
(72) Inventor: KUBOTANI, Tsuyoshi, Kyoto-shi, Kyoto 612-8501 (JP); FUKUSHIMA, Takaaki, Kyoto-shi, Kyoto 612-8501 (JP); ISHIDA, Yuya, Kyoto-shi, Kyoto 612-8501 (JP); ODA, Yuki, Kyoto-shi, Kyoto 612-8501 (JP); SATO, Masanobu, Kyoto-shi, Kyoto 612-8501 (JP); BABA, Masahiro, Kyoto-shi, Kyoto 612-8501 (JP); MISHIMA, Hiromitsu, Kyoto-shi, Kyoto 612-8501 (JP)
(74) Representative: TBK
(86) International application number: PCT/JP2021/039539
(87) International publication number: WO 2022/092109

(57) **Abstract**

A power storage apparatus includes a power storage module, a temperature acquirer, a state-of-charge calculator, and a charge controller. The power storage module includes a plurality of batteries connected to each other. The temperature acquirer acquires a temperature of the power storage module. The state-of-charge calculator calculates a state of charge of the power storage module. The charge controller charges the power storage module with a current value that is set based on the acquired temperature and the calculated state of charge.

## Description

### CROSS-REFERENCE TO RELATED APPLICATIONS

The present application claims priority from Japanese Patent Application No. 2020-179847 filed on October 27, 2020, the entire contents of which are hereby incorporated by reference.

### TECHNICAL FIELD

The disclosure relates to a power storage apparatus, a charging method, and a program.

### BACKGROUND OF INVENTION

Systems are known in which distributed power supplies, such as power storage apparatuses, are interconnected to electric power systems. The power storage apparatus in such a system may be provided outside a house to be used as an emergency power supply in times of disaster.

A secondary battery in the power storage apparatus is known to be increasingly degraded at high temperature and at low temperature. For example, Patent Literature 1 discloses a technology to decrease the current value if the ambient temperature is lower than a certain temperature when the plus or minus sign of a second order differential calculation value of charge current is varied to extend the lifetime of a battery.

### CITATION LIST

### PATENT LITERATURE

Patent Literature 1: International Publication No. 2017/013823

### SUMMARY

In an embodiment, a power storage apparatus includes a power storage module, a temperature acquirer, a state-of-charge calculator, and a charge controller. The power storage module includes a plurality of batteries connected to each other. The temperature acquirer acquires a temperature of the power storage module. The state-of-charge calculator calculates a state of charge of the power storage module. The charge controller charges the power storage module with a current value that is set based on the acquired temperature and the calculated state of charge.

In an embodiment, a charging method is for a power storage module including a plurality of batteries connected to each other. The charging method includes acquiring a temperature of a power storage module, calculating a state of charge of the power storage module, and charging the power storage module with a current value that is set based on the acquired temperature and the calculated state of charge.

In an embodiment, a program is used for charging of a power storage module including a plurality of batteries connected to each other. The program causes a computer to perform acquiring a temperature of a power storage module, calculating a state of charge of the power storage module, and charging the power storage module with a current value that is set based on the acquired temperature and the calculated state of charge.

### BRIEF DESCRIPTION OF THE DRAWINGS

FIG. 1 is a diagram illustrating an example of the configuration of a power storage system including a power storage apparatus according to an embodiment.
FIG. 2 is a graph illustrating the charging state of a battery using a charging method according to an embodiment.
FIG. 3 is a diagram illustrating a current value setting table used in the charging method according to the embodiment.
FIG. 4 is a flowchart illustrating the charging method according to the embodiment.
FIG. 5 indicates an example of the result of charge of the battery in the charging method according to the embodiment.
FIG. 6 indicates another example of the result of charge of the battery in the charging method according to the embodiment.
FIG. 7 is a graph illustrating the charging state of a battery using a charging method in related art.
FIG. 8 is a diagram illustrating a current value setting table used in the charging method in the related art.
FIG. 9 is a diagram illustrating an example of the configuration of a power storage system including a power storage apparatus according to another embodiment.
FIG. 10 is a diagram for describing a coefficient used in the power storage apparatus in FIG. 9.

### DESCRIPTION OF EMBODIMENTS

(Configuration of power storage system)

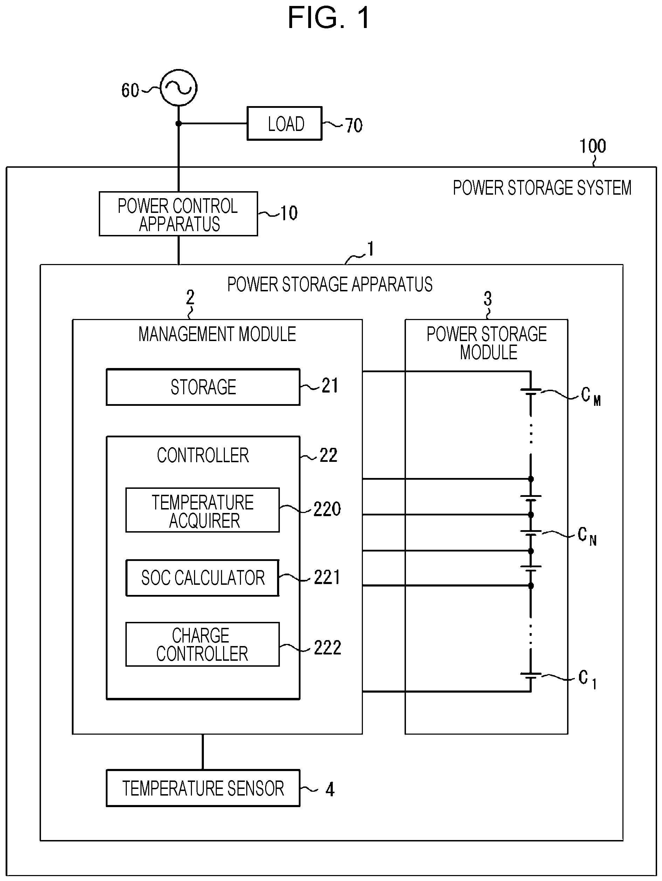

FIG. 1 is a diagram illustrating an example of the configuration of a power storage system 100 including a power storage apparatus 1 according to an embodiment of the disclosure. The power storage system 100 is connected to a power system 60 and supplies electric power to a load 70 connected to the power system 60. The load 70 may include an arbitrary electric device, such as a lighting, an air conditioner, or an information processing apparatus, which consumes the electric power. The power storage system 100 accumulates the electric power supplied from the power system 60 in the power storage apparatus 1.

The power storage system 100 includes a power control apparatus 10 and the power storage apparatus 1. The number of the power storage apparatuses 1 provided in the power storage system 100 is not limited. Although one power storage apparatus 1 is provided in the power storage system 100 in the example illustrated in FIG. 1, the power storage system 100 may include multiple power storage apparatuses 1. The multiple power storage apparatuses 1 may be connected in parallel to the power control apparatus 10. The power storage apparatus 1 is connected to the power system 60 and the load 70 via the power control apparatus 10.

The power control apparatus 10 is also referred to as a power conditioning system (PCS). In addition, the power control apparatus 10 may be referred to as a power conditioner. The power control apparatus 10 controls the operation of the power storage system 100 in an integrated manner to realize various functions. The power control apparatus 10 controls, for example, input and output of the electric power between the power storage apparatus 1, and the power system 60 and the load 70. The power control apparatus 10 converts, for example, direct-current power supplied from the power storage apparatus 1 into alternating-current power to supply the alternating-current power to the power system 60 or the load 70.

The power storage apparatus 1 accumulates the electric power supplied from the power system 60. The power storage apparatus 1 supplies the accumulated electric power to the load 70. In addition, the power storage apparatus 1 may supply to the power system 60 the electric power that can be sold. The power storage apparatus 1 may be provided, for example, outside a house to be used as an emergency power supply in times of disaster. The power storage apparatus 1 may be used in cold climates.

### (Configuration of power storage apparatus)

The power storage apparatus 1 according to the present embodiment includes a management module 2, a power storage module 3, and a temperature sensor 4. The management module 2 includes a storage 21 and a controller 22. The controller 22 includes a temperature acquirer 220, an SOC calculator 221, and a charge controller 222. FIG. 1 is an example. The power storage apparatus 1 may not include all the components illustrated in FIG. 1. The power storage apparatus 1 may include one or more components other than the components illustrated in FIG. 1.

The power storage module 3 includes multiple batteries C₁ to C_{M} connected in series to each other. M is an integer of two or more. M is, for example, 48. In the present embodiment, the multiple batteries C₁ to C_{M} are secondary batteries having the same configuration. An arbitrary one, among the multiple batteries C₁ to C_{M}, may be represented as a battery C_{N}. The power storage module 3 may be referred to as a battery.

The management module 2 manages the power storage module 3. In particular, the management module 2 monitors a state of charge (SOC, a charging rate) of the power storage module 3 to control charge and discharge.

The storage 21 stores programs and data as a storage unit. The storage 21 may temporarily store the result of processing in the controller 22. The storage 21 may include an arbitrary storage device, such as a semiconductor storage device, an optical storage device, or a magnetic storage device. The semiconductor storage device may include, for example, a semiconductor memory. The storage 21 may include storage devices of multiple types. The storage 21 may include a combination of a portable storage medium, such as a memory card, and a reader of the storage medium.

In the present embodiment, the data stored in the storage 21 includes a current value setting table. The current value setting table will be described in detail below.

The controller 22 is a processor, such as a central processing unit (CPU). The controller 22 may be an integrated circuit, such as a system-on-chip, in which another component is integrated. The controller 22 may be composed by combining multiple integrated circuits. The controller 22 controls the operation of the power storage apparatus 1 in an integrated manner to realize various functions.

The temperature acquirer 220 acquires the temperature of the power storage module 3, which is detected by the temperature sensor 4. The temperature acquirer 220 may acquire the temperature of the power storage module 3 constantly or may acquire the temperature intermittently (for example, at intermittent intervals of one to 600 seconds). Although the temperature to be acquired is the temperature of the power storage module 3 itself in the present embodiment, the temperature to be acquired is not limited to this. As another example, the temperature to be acquired may be the operating environment temperature of the power storage module 3. The operating environment temperature of the power storage module 3 may be the temperature in the power storage apparatus around the power storage module 3 or may be the air temperature of a location in which the power storage apparatus 1 is arranged.

The SOC calculator 221 calculates the SOC of the power storage module 3. A known method may be used for the calculation of the SOC. For example, the SOC calculator 221 measures and integrates the current flowing through the battery to calculate the SOC. The SOC calculator 221 may acquire the voltage of the power storage module 3 and may calculate open circuit voltage (OCV) using an internal resistance of the battery C_{N} or the like to calculate the SOC from the OCV and the SOC-OCV curve.

The charge controller 222 controls charge of the power storage module 3. The charge controller 222 charges the power storage module 3 with a current value that is set based on the temperature acquired by the temperature acquirer 220 and the SOC calculated by the SOC calculator 221. If a charge completion condition described below is met, the charge controller 222 terminates the charge of the power storage module 3. In the present embodiment, the charge controller 222 sets the current value using the current value setting table acquired from the storage 21. A charging method performed by the charge controller 222 will be described in detail below. Here, the charge controller 222 may determine the timing when the charge of the power storage module 3 is started, based on the SOC of the power storage module 3 or an instruction from the power control apparatus 10.

The temperature sensor 4 detects the temperature of the power storage module 3. In the present embodiment, the temperature sensor 4 is arranged in contact with or near the power storage module 3 to detect the temperature of the power storage module 3 itself. The temperature sensor 4 may be arranged at different locations depending on the temperature of the power storage module 3, which is used for setting of the current value by the controller 22. For example, when the air temperature of the location where the power storage apparatus 1 is arranged is used for the calculation for setting of the current value, the temperature sensor 4 may be arranged outside the power storage apparatus 1 or a position where the outside air is taken in.

### (Charging method)

As described above, the charge controller 222 in the power storage apparatus 1 charges the power storage module 3 with the current value, which is set based on the temperature and the SOC. Charging methods in related art have the following problems.

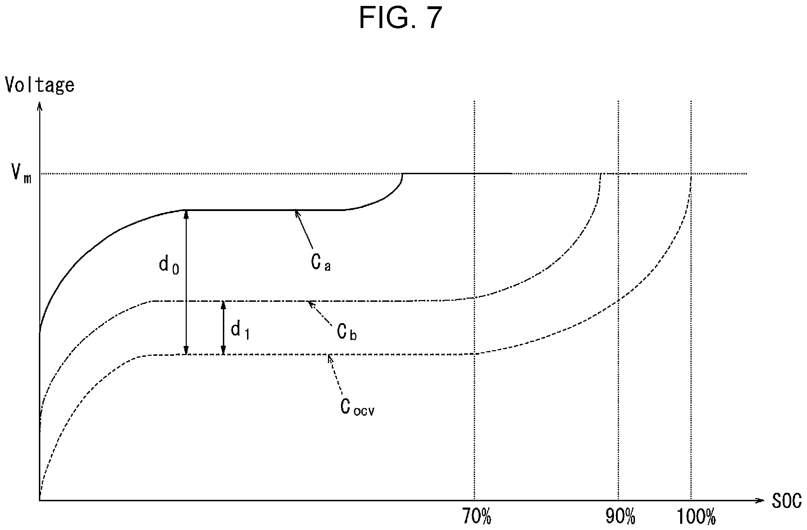

FIG. 7 is a graph illustrating the charging state of the battery C_{N} using a charging method in the related art. In a first charging method in the related art (hereinafter referred to as a first method in the related art), the charge of the battery is performed using the same current value as at ordinary temperature also at low temperature. Here, the ordinary temperature is, for example, 10 °C or higher. The low temperature is, for example, lower than 10 °C. Although the lower limit of the low temperature is, for example, -20 °C, the lower limit of the low temperature may be another temperature value or the lower limit of the low temperature may not be defined.

A characteristic curve Cₐ in FIG. 7 indicates the voltage and the SOC when the battery C_{N} is charged at the low temperature using the first method in the related art. Here, charge end voltage Vₘ is the voltage when the battery C_{N} is fully charged. If a state in which the charge end voltage Vₘ is detected is continued for a predetermined time (for example, 60 minutes) in the charge of the battery C_{N}, it is determined that the charge is completed. The charge end voltage Vₘ may be calculated by subtracting a measurement error dV (for example, 0.02 V) from an upper limit voltage Vₘₐₓ (for example, 3.57 V) defined for the battery C_{N}. As indicated by the characteristic curve Cₐ, the charging at the low temperature using the first method in the related art causes a problem in that the SOC when the charge is completed does not reach 90% or more, which is the target value, but is about 70%. This is because the internal resistance of the battery is made high to increase overvoltage d₀ due to the low temperature and, thus, it is determined that the charge is completed in a state in which the amount of charge is insufficient. Here, a characteristic curve C_{ocv} in FIG. 7 indicates theoretical open circuit voltage and SOC.

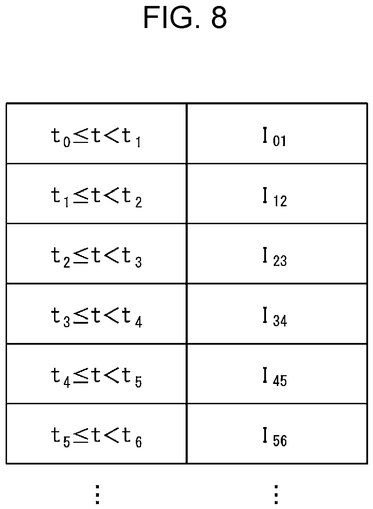

In a second charging method in the related art (hereinafter referred to as a second method in the related art), the charge of the battery is performed using a current value lower than that at the ordinary temperature at the low temperature. FIG. 8 is a diagram illustrating the current value setting table used in the second method in the related art. The current value setting table defines the relationship between the temperature and the SOC, and the current value. Referring to FIG. 8, t₀, t₁, t₂, t₃, t₄, t₅, and t₆ are, for example, -20 °C, -10 °C, -5 °C, 0 °C, 5 °C, 10 °C, and 15 °C, respectively. In the second method in the related art, the current value used for the charge is determined depending on which group a temperature (t) of the battery is classified into. Current values I₀₁ to I₄₅ at the low temperatures are lower than a current value I₅₆ at the ordinary temperature (t₅ ≤ t < t₆). In addition, I₀₁ < I₁₂ < I₂₃ < I₃₄ < I₄₅ < I₅₆ is established for the current values I₀₁ to I₅₆.

A characteristic curve C_{b} in FIG. 7 indicates the voltage and the SOC when the battery C_{N} is charged at the low temperature using the second method in the related art. In the second method in the related art, overvoltage d₁ is held down by making the current value to be set lower than the current value at the ordinary temperature against the increasing internal resistance of the battery due to the low temperature. In other words, in the second method in the related art, the current value is made low so that the voltage does not reach the charge end voltage Vₘ before the SOC reaches 90 % or more, which is the target value. As indicated by the characteristic curve C_{b}, in the charge using the second method in the related art, the SOC when the charge is completed is made higher than or equal to 90 %, which is the target value, at the low temperature. However, since the current value during the charge is constantly kept low, there is a problem in that the charge time is lengthened.

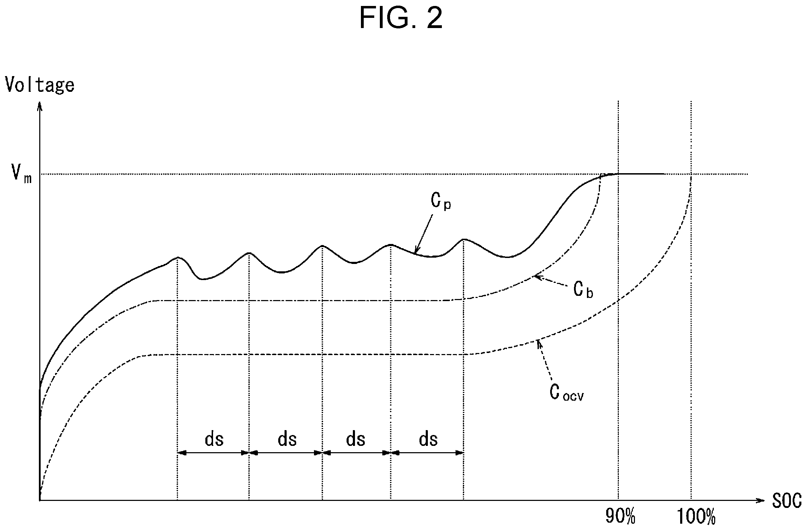

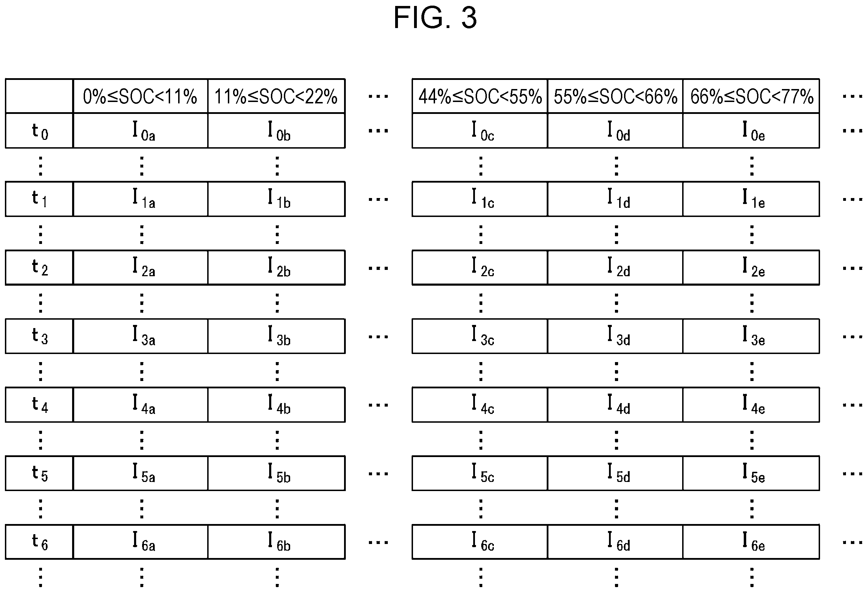

Against the problems of the charging method in the related art, the charge controller 222 in the power storage apparatus 1 according to the present embodiment charges the power storage module 3 while varying the current value during the charge based on the temperature and the SOC. FIG. 2 is a graph illustrating the charging state of the battery C_{N} using a charging method according to the present embodiment. FIG. 3 is a diagram illustrating the current value setting table used in the charging method according to the present embodiment. Since the same reference numerals and letters are used in FIG. 2 and FIG. 3 to identify the same components as in FIG. 7 and FIG. 8, a description of such components is omitted herein.

A characteristic curve Cₚ in FIG. 2 indicates the voltage and the SOC when the battery C_{N} is charged using the charging method according to the present embodiment. In the charging method according to the present embodiment, the current value is varied so as to be decreased as the SOC of the power storage module 3 is increased while shortening the time until the charge is completed by using a current value higher than that in the second method in the related art to make the SOC when the charge is completed higher than or equal to 90 %, which is the target value.

As illustrated in FIG. 3, not only the temperature but also the SOC is divided into multiple groups in the current value setting table in the present embodiment and the current value is determined depending on the combination of the groups of the temperature and the SOC. Although the SOC may be divided into the groups having substantially the same numerical value range, the division of the SOC is not limited to this. In the present embodiment, the SOC is divided into the groups having a range of 11% or 12%. For example, a width ds of the SOC in FIG. 2 may be 11%. Although the temperature may be divided into the groups having substantially the same numerical value range, the division of the temperature is not limited to this. In the present embodiment, the temperature is divided into the groups having a range of 1 °C.

In the charge of the power storage module 3, the charge controller 222 classifies the SOC calculated by the SOC calculator 221 into one of the multiple groups and sets the current value in accordance with the classified group. Here, when a first group and a second group having a higher SOC are set for the SOC and the first group and the second group are classified into the same group of the temperature, which is acquired by the temperature acquirer 220, the charge controller 222 sets a second current value corresponding to the second group to a value lower than or equal to a first current value corresponding to the first group. This will be described with reference to FIG. 3. For example, in a temperature group t1, second current I_{1d} corresponding to the second group "55% ≤ SOC < 66%" of the SOC is lower than or equal to first current I_{1c} corresponding to the first group "44% ≤ SOC < 55%" of the SOC. For example, in a temperature group t3, second current I₃ₑ corresponding to the second group "66% ≤ SOC < 77%" of the SOC is lower than or equal to first current I_{3c} corresponding to the first group "44% ≤ SOC < 55%" of the SOC. In the example in FIG. 3, Iⱼₐ ≥ I_{jb} ≥ I_{jc} ≥ I_{jd} ≥ Iⱼₑ is established for current values Iⱼₐ, I_{jb}, I_{jc}, I_{jd}, and Iⱼₑ, where j is a parameter indicating any of integers 0 to 6. However, the case in which all the SOC groups have the same current value (corresponding to the second method in the related art) is excluded in this inequality.

In addition, the charge controller 222 classifies the temperature acquired by the temperature acquirer 220 into one of the multiple groups and sets the current value in accordance with the classified group. For example, when the temperature group is changed in response to the increased or decreased temperature during the charge of the power storage module 3, the current value corresponding to the temperature group after the change is set. Here, when a third group and a fourth group having a lower temperature are set for the temperature and the third group and the fourth group are classified into the same group of the calculated SOC, the charge controller 222 sets a fourth current value corresponding to the fourth group to a value lower than or equal to a third current value corresponding to the third group. This will be described with reference to FIG. 3. For example, in an SOC group "11% ≤ SOC < 22%", second current I_{1b} corresponding to the fourth group "t₁" of the temperature is lower than or equal to first current I_{2b} corresponding to the third group "t₂" of the temperature. For example, in an SOC group "44% ≤ SOC < 55%", second current I_{3c} corresponding to the fourth group "t₃" of the temperature is lower than or equal to first current I_{5c} corresponding to the third group "t₅" of the temperature. In the example in FIG. 3, I₀ₓ ≤ I₁ₓ ≤ I₂ₓ ≤ I₃ₓ ≤ I₄ₓ ≤ I₅ₓ ≤ I₆ₓ is established for current values I₀ₓ, I₁ₓ, I₂ₓ, I₃ₓ, I₄ₓ, I₅ₓ, and I₆ₓ, where x is a parameter indicating any of {a, b, c, d, and e}. However, the case in which all the temperature groups have the same current value is excluded in this inequality.

The charge controller 222 acquires the SOC and the temperature of the power storage module 3 and determines the current value based on the combination of the SOC and the temperature and the current value setting table to charge the power storage module 3. As illustrated in FIG. 2, the characteristic curve Cₚ in the charging method according to the present embodiment has wavy portions in which the voltage is temporarily decreased when the SOC has predetermined values in response to an increase in the SOC of the power storage module 3. The predetermined values of the SOC at which the voltage is decreased correspond to boundaries of the SOC groups. In the example in FIG. 3, the predetermined values are, for example, 44%, 55%, and 66%. When the group is changed in response to an increase of the SOC during the charge, a lower current value is set by the charge controller 222. At this time, the voltage of the power storage module 3 is decreased. Then, the voltage of the power storage module 3 is gradually increased in response to, for example, a variation in the internal resistance caused by an increase in temperature in the power storage module 3. Accordingly, the characteristic curve Cₚ has the wavy portions.

As described above, if the state in which the charge end voltage Vₘ is detected is continued for a predetermined time in the charge of the battery C_{N}, it is determined that the charge is completed. A current value higher than that in the second method in the related art is used in the charging method according to the present embodiment to shorten the time until the charge is completed. Accordingly, the voltage may reach the charge end voltage Vₘ before the SOC reaches the 90% or more, which is the target value. However, the voltage is decreased when the SOC reaches a predetermined value in the charging method according to the present embodiment. Accordingly, the above state is not continued to an extent in which it is determined that the charge is completed even if the voltage temporarily reaches the charge end voltage Vₘ before the charge is completed. Consequently, the SOC when the charge is completed is capable of being set to a value higher than or equal to 90%, which is the target value, in the charging method according to the present embodiment. Here, many boundaries of the SOC groups associated with the current values (many predetermined SOC values at which the voltage is decreased) are preferably set in order not to continue the state in which the voltage is temporarily reaches the charge end voltage Vₘ, that is, in order to improve the effect of avoiding erroneous determination of the completion of the charge. The SOC is preferably divided into groups having a range of at least 15% or less. For example, the SOC may be divided into groups having a range of 11% or 12%, as in the present embodiment. The SOC may be divided into groups having a narrower range (for example, a range of 8%).

### (Power storage method)

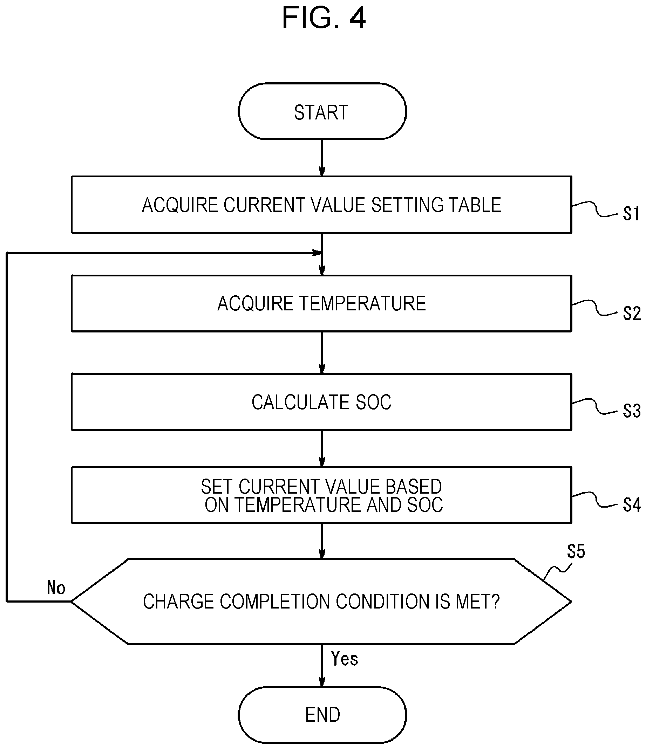

FIG. 4 is a flowchart illustrating the charging method according to the present embodiment. The controller 22 in the power storage apparatus 1 charges the power storage module 3 in accordance with the flowchart illustrated in FIG. 4.

The charge controller 222 in the controller 22 acquires the current value setting table from the storage 21 (Step S1).

The temperature acquirer 220 in the controller 22 acquires the temperature of the power storage module 3 from the temperature sensor 4 (Step S2).

The SOC calculator 221 in the controller 22 acquires information (for example, the measurement values of the voltage and the current of the battery C_{N}), which is necessary for the calculation, from the power storage module 3 to calculate the SOC of the power storage module 3 (Step S3).

The charge controller 222 in the controller 22 sets the current value used for the charge of the power storage module 3 based on the temperature acquired by the temperature acquirer 220 and the SOC calculated by the SOC calculator 221 (Step S4). At this time, the charge controller 222 uses the current value setting table described above. The charge controller 222 charges the power storage module 3 with the set current value.

If the charge completion condition is met (Yes in Step S5), the charge controller 222 in the controller 22 terminates the charge process. Here, the charge completion condition may be continuation of the state in which the measurement value of the voltage of any battery C_{N} reaches the charge end voltage Vₘ for a predetermined time (for example, 60 minutes). The charge controller 222 may receive the measurement value of the voltage of the battery C_{N}, which is acquired by the SOC calculator 221, to use the received measurement value for the determination of the completion of the charge.

If the charge completion condition is not met (No in Step S5), the controller 22 goes back to Step S2.

### (Examples)

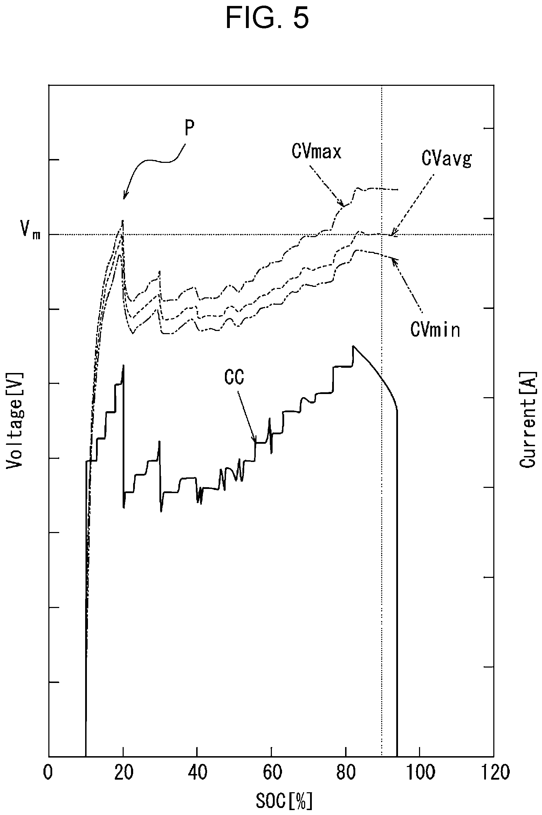

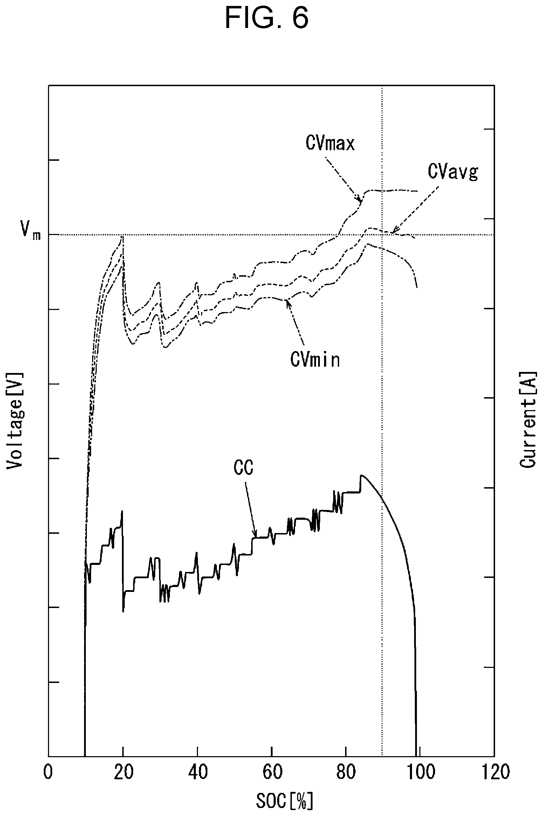

The charging method described above was performed in the power storage apparatus 1 according to the present embodiment to charge the power storage module 3 at the low temperature. FIG. 5 and FIG. 6 indicate the results of the charge of the battery C_{N} in experiments under different temperature conditions. An example the result of which is illustrated in FIG. 5 is hereinafter referred to as a first example. An example the result of which is illustrated in FIG. 6 is hereinafter referred to as a second example.

In the first example, the temperature of the power storage module 3 was -10 °C and the SOC before the power storage module 3 is charged, that is, the SOC in an initial state was 10%. Referring to FIG. 5, CC denotes the measurement value of the current of the power storage module 3. CVₘₐₓ denotes the measurement value of the voltage of the battery C_{N} that exhibits the maximum voltage when the charge is completed, among the batteries C_{N}. CVₘᵢₙ denotes the measurement value of the voltage of the battery C_{N} that exhibits the minimum voltage when the charge is completed, among the batteries C_{N}. CV_{avg} denotes the average of the measurement values of the voltages of all the batteries C_{N}. In the first example, the SOC when the charge is completed was 94.2%, which is higher than or equal to the 90%, which is the target value. As indicated by P in FIG. 5, the voltages of some batteries C_{N} reached the charge end voltage Vₘ at the SOC of 19%. After the state in which the voltage reaches the charge end voltage Vₘ was continued for five minutes, the voltage was decreased at the SOC of 22%. Here, the charge completion condition is continuation of the state in which the voltage reaches the charge end voltage Vₘ for 60 minutes or more. Accordingly, the erroneous determination of the completion of the charge did not occur in the first example. In addition, the charge time was shortened to one half or less of that in the second method in the related art.

In the second example, the temperature of the power storage module 3 was -15 °C. The other conditions were the same as in the first example. In the second example, the SOC when the charge is completed was 98.4 %, which is higher than or equal to 90%, which is the target value. Although the voltages of some batteries C_{N} reached the charge end voltage Vₘ, as illustrated in FIG. 6, the duration was within one minute. Accordingly, the erroneous determination of the completion of the charge did not occur in the second example. In addition, the charge time was shortened to one third or less of that in the second method in the related art.

As apparent from the results of the examples, in the power storage apparatus 1 and the charging method according to the present embodiment, the sufficient charge is enabled even in the low temperature state with the above configuration and through the above process. In addition, with the power storage apparatus 1 and the charging method according to the present embodiment, the charge time can be greatly shortened, compared with that in the charging method in the related art in which the charge of the battery is performed using a current value lower than that at the ordinary temperature at the low temperature.

Although the embodiment is described based on the drawings and the examples, various variations and changes are easily made based on the disclosure by the person skilled in the art. Accordingly, it is noted that these variations and changes are included in the scope of the disclosure. For example, functions and so on included in the respective components, the respective means, the respective steps, and the likes are capable of being rearranged with no logical contradiction. Multiple means and/or steps may be combined to one or may be divided.

In the above embodiment, the charge controller 222 sets the current value in accordance with the classified group and sets the current value so as to be decreased in response to an increase in the SOC also at the ordinary temperature. The high internal resistance of the power storage module 3 causes a problem particularly at the low temperature. Accordingly, the charge controller 222 may set the current value to a certain value that is not dependent on the SOC if the acquired temperature is higher than a predetermined threshold value (for example, 10 °C). For example, t₅ (10 °C) and t₆ (15 °C) in FIG. 3 are the ordinary temperatures. I₅ₐ, I_{5b}, I_{5c}, I_{5d}, and I₅ₑ in FIG. 3 may have the same value. I₆ₐ, I_{6b}, I_{6c}, I_{6d}, and I₆ₑ in FIG. 3 may have the same value. The value I₅ may be equal to the value I₆.

Although the apparatus and the method are focused on in the description of the embodiment, the embodiment according to the disclosure may be realized as programs executed by a processor in the apparatus or a storage medium having the programs recorded thereon. The programs and the storage medium are included in the scope of the disclosure.

For example, the management module 2 may be realized by a computer including storage devices, such as a memory and a hard disk drive, and control units, such as a central processing unit (CPU) and another processor. At this time, the storage 21 may be realized by the storage device in the computer. The controller 22 may be realized by the control unit in the computer. The programs may be stored in the storage device and may be read out from the control unit for execution.

The programs stored in the storage 21 may include programs causing the controller 22 to function as the temperature acquirer 220, the SOC calculator 221, and the charge controller 222. The controller 22 may execute instructions included in the programs stored in the storage 21 to realize the various functions. The controller 22 may execute the instructions of the programs read from the storage 21 to realize the functions of the temperature acquirer 220, the SOC calculator 221, and the charge controller 222.

In the above embodiment, the charge controller 222 charges the power storage module 3 with the current value, which is set based on the temperature and the SOC. Here, the current value to be set may be set based on the quantity of state of the power storage module 3, which is different from the temperature and the SOC. For example, as another embodiment, the controller 22 may use the current value considering states of health (SOH, soundness or the degree of degradation) of the power storage module 3. In other words, the charge controller 222 may charge the power storage module 3 with the current value that is set based on the acquired temperature, the calculated SOC, and the calculated SOH. Here, the SOH indicates the state of degradation of the power storage module 3 and is calculated as the ratio of the current full charging capacity with respect to the initial full charging capacity (or the rated capacity). The other embodiment will be described in detail below.

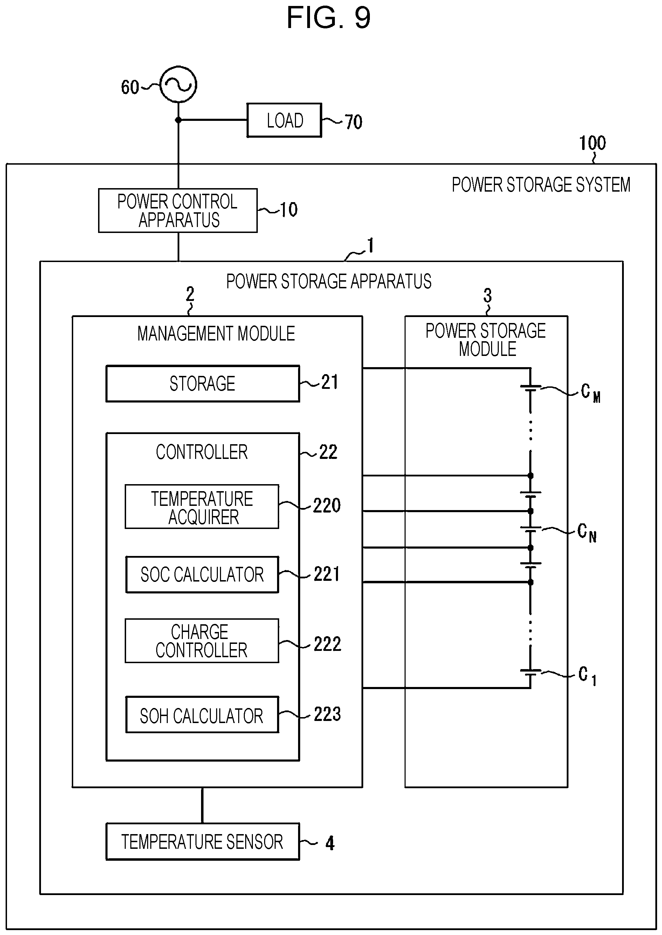

FIG. 9 is a diagram illustrating an example of the configuration of the power storage system 100 including the power storage apparatus 1 according to another embodiment. The embodiment in FIG. 9 differs from the above embodiment (refer to FIG. 1) in that the controller 22 further includes an SOH calculator 223. In addition, the charge controller 222 adjusts the current value using the SOH. Since the other components in FIG. 9 are the same as those in FIG. 1, a description of the other components is omitted herein.

The SOH calculator 223 calculates the SOH of the power storage module 3. A known method may be used for the calculation of the SOH. For example, the SOH calculator 223 may acquire information about usage environment including the temperature to calculate the SOH of the power storage module 3 using a mathematical model of the degradation using the information about the usage environment as a parameter. In addition, for example, the SOH calculator 223 may acquire the amount of discharge of the power storage module 3 from the full charge state to complete discharge and may calculate the ratio of the amount of discharge with respect to the rated capacity to calculate the SOH.

Although the charge controller 222 sets the current value using the current value setting table acquired from the storage 21, as described above, the charge controller 222 adjusts the current value by multiplying the set current value (hereinafter referred to as a current value before adjustment) by the value of the SOH (hereinafter denoted as Q_{SOH}) and a coefficient α. In the other embodiment, a current value after adjustment is used for the charge of the power storage module 3. Current value after adjustment I_{adj} is calculated by I_{adj} = I × (Q_{SOH} × α) where the current value before adjustment is denoted by I.

However, if (Q_{SOH} × α) exceeds one, (Q_{SOH} × α) is set to one. In other words, if (Q_{SOH} × α) exceeds one, I_{adj} = I.

Since the internal resistance of the battery is increased, compared with that at the initial state (during manufacturing), to increase the overvoltage if the power storage module 3 is degraded with time, it may be determined that the charge is completed with the amount of charge smaller than that in the initial state. Accordingly, in the power storage module 3 subjected to the degradation with time, adjustment is preferably performed so that the charge is performed with a current value smaller than that in the above embodiment particularly at the low temperature. The degree of the degradation with time of the power storage module 3 is determined from the SOH. The power storage apparatus 1 according to the other embodiment performs the charge with the current value after adjustment I_{adj} to enable sufficient charge at the low temperature state even for the power storage module 3 subjected to the degradation with time.

Here, Q_{SOH} is a value lower than or equal to one. For example, when the power storage module 3 is not so degraded and the SOH is 90%, Q_{SOH} is 0.9. For example, when the degradation of the power storage module 3 is advanced and the SOH is 40%, Q_{SOH} is 0.4. The coefficient α is introduced so that the current value after adjustment is not excessively decreased (that is, the charge time is not lengthened) particularly when the degradation of the power storage module 3 is advanced. The coefficient α has a value higher than one.

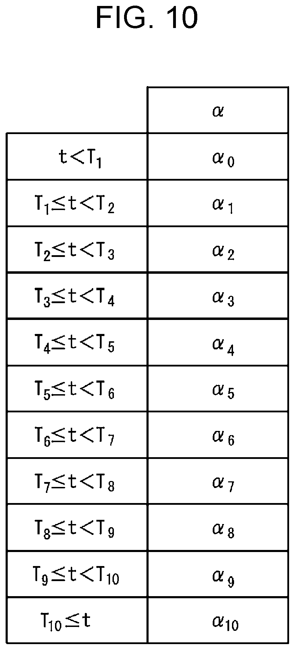

FIG. 10 is a diagram for describing the coefficient α. The coefficient α is set based on the temperature (t) of the battery. In the example in FIG. 10, T₁ < T₂ < T₃ < T₄ < T₅ < T₆ < T₇ < T₈ < T₉ < T₁₀ is established for threshold temperatures T₁ to T₁₀. 1 < α₀ < α₁ < α₂ < α₃ < α₄ < α₅ < α₆ < α₇ < α₈ < α₉ < α₁₀ is established for values α₀ to α₁₀ of the coefficient α. As one example, T₁ may be 15 °C. In this example, when the temperature (t) of the battery is 15 °C or less, the coefficient α is set to α₀. For example, α₀ may be 1.1. For example, when Q_{SOH} is 0.9, (Q_{SOH} × α) is 0.99. If Q_{SOH} is 0.4 because the degradation of the power storage module 3 is advanced, (Q_{SOH} × α) is 0.44. At this time, the current value after adjustment (I_{adj}) is set to a value lower than one half of the current value in the current value setting table. Adjusting the current value in accordance with the SOH in the manner described above enables sufficient charge at the low temperature even for the power storage module 3 subjected to the degradation with time.

As one example, T₁₀ may be 24 °C. In this example, the coefficient α is set to α₁₀ if the temperature (t) of the battery is 24 °C or higher. For example, α₁₀ may be 2.0. At this time, since the value of (Q_{SOH} × α) exceeds one if Q_{SOH} is higher than 0.5, (Q_{SOH} × α) is set to one ((Q_{SOH} × α) = 1). In other words, the current value after adjustment is equal to the current value before adjustment. At high temperatures at which the influence of the increase in the internal resistance, which is caused by the degradation of the power storage module 3, is not so large, the current value of the charge is set in accordance with the current value setting table, as in the above embodiment.

In the disclosure, representations of "first", "second," and so on are identifiers for discriminating the corresponding components. The numbers of the components discriminated with the representations of "first", "second", and so on in the disclosure may be replaced. The replacement of the identifiers is simultaneously performed. The components are discriminated after the replacement of the identifiers. The identifiers may be deleted. The components from which the identifiers are deleted are discriminated with reference numerals and letters. Interpretation of the order of the components and existence of the identifiers of smaller numbers are not to be based only on the representations of the identifiers, such as "first" and "second", in the disclosure.

"Sustainable development goals: SDGs" have been defined as seventeen international goals, which has been adopted in United Nations Sustainable Development Summit on September 2015. The power storage apparatus 1 and the charging method according to an embodiment may contribute to achievement of goals, such as "7. Affordable and Clean Energy", "9. Industry, Innovation and Infrastructure", and " 11. Sustainable Cities and Communities", among the seventeen goals of the SDGs.

### REFERENCE SIGNS

1 power storage apparatus
2 management module
3 power storage module
4 temperature sensor
10 power control apparatus
21 storage
22 controller
60 power system
70 load
100 power storage system
220 temperature acquirer
221 SOC calculator
222 charge controller
223 SOH calculator

## Claims

1. A power storage apparatus comprising:
a power storage module including a plurality of batteries connected to each other;
a temperature acquirer that acquires a temperature of the power storage module;
a state-of-charge calculator that calculates a state of charge of the power storage module; and
a charge controller that charges the power storage module with a current value that is set based on the acquired temperature and the calculated state of charge.

2. The power storage apparatus according to claim 1,
wherein the charge controller classifies the calculated state of charge into one of a plurality of groups and sets the current value in accordance with the classified group, and
wherein, when a first group and a second group having a higher state of charge are set for the state of charge and the first group and the second group are classified into a same group of the acquired temperature, the charge controller sets a second current value corresponding to the second group to a value lower than or equal to a first current value corresponding to the first group.

3. The power storage apparatus according to claim 1 or 2,
wherein the charge controller classifies the acquitted temperature into one of a plurality of groups and sets the current value in accordance with the classified group, and
wherein, when a third group and a fourth group having a lower temperature are set for the temperature and the third group and the fourth group are classified into a same group of the calculated state of charge, the charge controller sets a fourth current value corresponding to the fourth group to a value lower than or equal to a third current value corresponding to the third group.

4. The power storage apparatus according to any of claims 1 to 3,
wherein the charge controller sets the current value to a certain value that is not dependent on the calculated state of charge if the acquired temperature is higher than a predetermined threshold value.

5. The power storage apparatus according to any of claims 1 to 4, further comprising:
a storage that stores a current value setting table that defines relationship between the temperature and the state of charge, and the current value,
wherein the charge controller sets the current value using the current value setting table acquired from the storage.

6. The power storage apparatus according to any of claims 1 to 5, further comprising:
a state-of-health calculator that calculates a state of health of the power storage module,
wherein the charge controller charges the power storage module with a current value that is set based on the acquired temperature, the calculated state of charge, and the calculated state of health.

7. A charging method for a power storage module including a plurality of batteries connected to each other, the charging method comprising:
acquiring a temperature of a power storage module;
calculating a state of charge of the power storage module; and
charging the power storage module with a current value that is set based on the acquired temperature and the calculated state of charge.

8. A program used for charge of a power storage module including a plurality of batteries connected to each other, the program causing a computer to perform:
acquiring a temperature of a power storage module;
calculating a state of charge of the power storage module; and
charging the power storage module with a current value that is set based on the acquired temperature and the calculated state of charge.
